# EUROPEAN PATENT APPLICATION

(11) **EP 4 665 120 A1**
(43) Date of publication of application: **17.12.2025**
(21) Application number: 25714263.8
(22) Date of filing: 26.02.2025
(51) Int. Cl.: H10F 77/20, H10F 19/90

(54) **SOLAR CELL AND SOLAR MODULE**

(30) Priority: 30.04.2024 CN 202420941767 U
(71) Applicant: Longi Solar Technology (Xi'an) Co., Ltd., Xi'an, Shaanxi 710000 (CN)
(72) Inventor: JIANG, Haiyan, Xi'an, Shaanxi 710000 (CN); LI, Hui, Xi'an, Shaanxi 710000 (CN); BAI, Minghua, Xi'an, Shaanxi 710000 (CN); CHU, Yangyang, Xi'an, Shaanxi 710000 (CN); DANG, Zhangwei, Xi'an, Shaanxi 710000 (CN); ZHU, Huijun, Xi'an, Shaanxi 710000 (CN); PING, Feilin, Xi'an, Shaanxi 710000 (CN)
(74) Representative: Grünecker Patent- und Rechtsanwälte PartG mbB
(86) International application number: PCT/CN2025/079298
(87) International publication number: WO 2025/227906

(57) **Abstract**

The present application discloses a solar cell and a photovoltaic module, and relates to the field of solar cell technologies, to resolve a problem of bending or even hidden cracking of a solar cell body due to a large difference between shrinkage and pulling forces that a first surface and a second surface of the solar cell body are subjected to during soldering. The solar cell includes a solar cell body, a first electrode structure, and a second electrode structure. The first electrode structure includes a first edge connection structure close to a first edge and a second edge connection structure close to a second edge. The second electrode structure includes a third edge connection structure close to the first edge, and a fourth edge connection structure close to the second edge. A distance between the first edge connection structure and the first edge is less than a distance between the third edge connection structure and the first edge. A distance between the second edge connection structure and the second edge is less than a distance between the fourth edge connection structure and the second edge.

## Description

### CROSS-REFERENCE TO RELATED APPLICATIONS

The present application claims priority and benefits to Chinese Patent Application No. 202420941767.3, filed on April 30, 2024, which is incorporated herein by reference in its entirety.

### TECHNICAL FIELD

The present application relates to the technical field of solar cells, and in particular, to a solar cell and a photovoltaic module.

### BACKGROUND

A photovoltaic module is generally formed by a plurality of solar cell strings, and each of the plurality of solar cell strings is formed by a plurality of solar cells. In a process of preparing a solar cell string, the plurality of solar cells are generally soldered in series through interconnectors.

During series soldering, a first portion of an interconnector is soldered to a front surface of a previous solar cell, a second portion of the interconnector is soldered to a back surface of a next solar cell, and the interconnector is bent during transition from the previous solar cell to the next solar cell.

The foregoing solar cell generally includes a solar cell body, a plurality of pads, and a plurality of bus electrodes. The solar cell body has a first surface and a second surface opposite to the first surface. To resolve a problem of stress concentration during pad soldering, it is usually set that an orthographic projection of an end pad located on the first surface on the solar cell body and an orthographic projection of an end pad located at the second surface on the solar cell body do not completely coincide. In addition, during soldering of the interconnector, the end pads are most affected by shrinkage and pulling forces of the interconnector. Therefore, if positions of the end pads are improperly arranged, and during soldering, shrinkage and pulling forces that the first surface and the second surface of the solar cell body are subjected to are greatly different, usually resulting in bending or even hidden cracking of the solar cell body.

### SUMMARY

An objective of the present application is to provide a solar cell and a photovoltaic module, to reduce a probability of bending or even hidden cracking of a solar cell body, to ensure quality of a finally obtained photovoltaic module.

To implement the foregoing objective, according to a first aspect, the present application provides a solar cell. The solar cell includes a solar cell body. The solar cell body has a first surface and a second surface opposite to the first surface. The solar cell body has a first edge and a second edge opposite to the first edge along a first direction. The solar cell further includes a first electrode structure and a second electrode structure formed on the first surface and the second surface, respectively. The first electrode structure includes at least two first connection structures distributed at intervals along the first direction. The second electrode structure includes at least two second connection structures distributed at intervals along the first direction. The at least two first connection structures include a first edge connection structure close to the first edge and a second edge connection structure close to the second edge. The at least two second connection structures include a third edge connection structure close to the first edge and a fourth edge connection structure close to the second edge. A distance between the first edge connection structure and the first edge is less than a distance between the third edge connection structure and the first edge. A distance between the second edge connection structure and the second edge is less than a distance between the fourth edge connection structure and the second edge.

Compared with the related art, in the solar cell provided in the present application, a distance between the first edge connection structure and the first edge is less than a distance between the third edge connection structure and the first edge. A distance between the second edge connection structure and the second edge is less than a distance between the fourth edge connection structure and the second edge. In view of the above, after actual soldering, the first surface of the solar cell body, the first edge connection structure, and the second edge connection structure are all subjected to a pulling force (which is referred to as a first pulling force for short for convenience of subsequent description) in a direction toward an interior of the solar cell body. The second surface of the solar cell body, the third edge connection structure, and the fourth edge connection structure are all subjected to a pulling force (which is referred to as a second pulling force for short for convenience of subsequent description) in a direction toward the interior of the solar cell body. When the foregoing solution is adopted, it can be ensured that a perpendicular midline of a connection line between the first edge connection structure and the second edge connection structure and a perpendicular midline of a connection line between the third edge connection structure and the fourth edge connection structure are close, and are located in a middle region of the solar cell. In this case, the first pulling force and the second pulling force can basically offset each other or offset each other, to basically balance or balance impact of pulling forces of an interconnector on the first surface and the second surface, so that impact of shrinking of the interconnector on the first surface of the solar cell body and impact of shrinking of the interconnector on the second surface of the solar cell body are balanced as much as possible, thereby reducing or eliminating a probability of bending or even hidden cracking of the solar cell body, to ensure quality of a finally obtained photovoltaic module.

In an embodiment, a difference between the distance between the first edge connection structure and the first edge and the distance between the third edge connection structure and the first edge is equal to a difference between the distance between the second edge connection structure and the second edge and the distance between the fourth edge connection structure and the second edge.

When the foregoing solution is adopted, a perpendicular midline of a connection line between the first edge connection structure and the second edge connection structure and a perpendicular midline of a connection line between the third edge connection structure and the fourth edge connection structure are infinitely close to or coincide with each other. In this case, the first pulling force and the second pulling force can almost completely offset each other, which can better prevent the solar cell body from bending or even hidden cracking.

In an embodiment, the distance between the first edge connection structure and the first edge is greater than or equal to 4.5 mm and less than or equal to 8.5 mm. The distance between the second edge connection structure and the second edge is greater than or equal to 5.5 mm and less than or equal to 9.5 mm. The distance between the third edge connection structure and the first edge is greater than or equal to 5 mm and less than or equal to 9 mm. The distance between the fourth edge connection structure and the second edge is greater than or equal to 6.5 mm and less than or equal to 10.5 mm.

When the foregoing technical solution is adopted, stress concentration is reduced in response to ensuring a conductive connector (for example, an interconnector) is stably soldered to the first edge connection structure, the second edge connection structure, the third edge connection structure, and the fourth edge connection structure after actual soldering.

In an embodiment, along the first direction, an overlap rate of an orthographic projection of the first edge connection structure on the solar cell body and an orthographic projection of the third edge connection structure, corresponding to the first edge connection structure, on the solar cell body is greater than or equal to 0 and less than 70%.

Along the first direction, an overlap rate of an orthographic projection of the second edge connection structure on the solar cell body and an orthographic projection of the fourth edge connection structure, corresponding to the second edge connection structure, on the solar cell body is greater than or equal to 0 and less than 70%.

When the foregoing technical solution is adopted, when the two overlap rates are both equal to 0, the first edge connection structure and the third edge connection structure are completely staggered, and the second edge connection structure and the fourth edge connection structure are completely staggered. In this case, during actual soldering, a probability that soldering stress concentration occurs at the first connection structures and the second connection structures on the first surface and the second surface of the solar cell can be further reduced, to ensure soldering reliability of a finally obtained photovoltaic module. Further, the overlap rate is less than 70%, which not only avoids stress concentration caused by an excessively large overlap rate, but also provides high flexibility for design of the pads.

In an embodiment, along the first direction, an overlap rate of an orthographic projection of the first edge connection structure on the solar cell body and an orthographic projection of the third edge connection structure, corresponding to the first edge connection structure, on the solar cell body is equal or not equal to an overlap rate of an orthographic projection of the second edge connection structure on the solar cell body and an orthographic projection of the fourth edge connection structure, corresponding to the second edge connection structure, on the solar cell body.

In an embodiment, along the first direction, when an overlap rate of an orthographic projection of the first edge connection structure on the solar cell body and an orthographic projection of the third edge connection structure, corresponding to the first edge connection structure, on the solar cell body is equal to 0, an overlap rate of an orthographic projection of the second edge connection structure on the solar cell body and an orthographic projection of the fourth edge connection structure, corresponding to the second edge connection structure, on the solar cell body is greater than 50% and less than 100%. Alternatively, along the first direction, when the overlap rate of the orthographic projection of the second edge connection structure on the solar cell body and the orthographic projection of the fourth edge connection structure, corresponding to the second edge connection structure, on the solar cell body is equal to 0, the overlap rate of the orthographic projection of the first edge connection structure on the solar cell body and the orthographic projection of the third edge connection structure, corresponding to the first edge connection structure, on the solar cell body is greater than 50% and equal to 100%.

When the foregoing technical solution is adopted, in response to reducing a probability that soldering stress concentration occurs at the first connection structures and the second connection structures on the first surface and the second surface of the solar cell, concentrated distribution of the first edge connection structure and the second edge connection structure can be avoided or concentrated distribution of the third edge connection structure and the fourth edge connection structure can be avoided, to ensure uniform current collection.

In an embodiment, the at least two first connection structures further include first intermediate connection structures located between the first edge connection structure and the second edge connection structure. Heights of the first intermediate connection structures are equal to a height of the first edge connection structure. The height of the first edge connection structure is equal to a height of the second edge connection structure.

In this case, it can be ensured that the conductive connector is firmly connected to the first edge connection structure, the second edge connection structure, and the first intermediate connection structures, to ensure quality of the solar cell. Further, heights of the first intermediate connection structures being greater than a height of the first edge connection structure and a height of the second edge connection structure can also be avoided from causing the conductive connector to be raised, thereby avoiding hidden cracking or fragmentation of the solar cell.

Cross-sectional areas of the first intermediate connection structures are smaller than a cross-sectional area of the first edge connection structure. The cross-sectional area of the first edge connection structure is equal to a cross-sectional area of the second edge connection structure. Cross sections of the first intermediate connection structures, a cross section of the first edge connection structure, and a cross section of the first edge connection structure are all parallel to the solar cell body.

In this case, an area by which the first intermediate connection structures shield the solar cell body can be reduced, to improve utilization of light by the solar cell, thereby improving efficiency of the solar cell.

In an embodiment, the at least two second connection structures further include second intermediate connection structures located between the third edge connection structure and the fourth edge connection structure. Heights of the second intermediate connection structures are equal to a height of the third edge connection structure. The height of the third edge connection structure is equal to a height of the fourth edge connection structure.

In this case, it can be ensured that the conductive connector is firmly connected to the third edge connection structure, the fourth edge connection structure, and the second intermediate connection structures, to ensure quality of the solar cell. Further, heights of the second intermediate connection structures being greater than a height of the third edge connection structure and a height of the fourth edge connection structure can also be avoided from causing the conductive connector to be raised, thereby avoiding hidden cracking or fragmentation of the solar cell.

Cross-sectional areas of the second intermediate connection structures are smaller than a cross-sectional area of the third edge connection structure. A cross-sectional area of the third edge connection structure is equal to a cross-sectional area of the fourth edge connection structure. Cross sections of the second intermediate connection structures, a cross section of the third edge connection structure, and a cross section of the fourth edge connection structure are all parallel to the solar cell body.

In this case, an area by which the second intermediate connection structures shield the solar cell body can be reduced, to improve utilization of light by the solar cell, thereby improving efficiency of the solar cell.

In an embodiment, the at least two first connection structures include at least two first intermediate connection structures. Orthographic projections of half of the first intermediate connection structures on the solar cell body do not overlap with orthographic projections of the second intermediate connection structures on the solar cell body.

When the foregoing technical solution is adopted, during actual soldering, a probability that soldering stress concentration occurs at the first connection structures and the second connection structures on the first surface and the second surface of the solar cell can be further reduced, to ensure soldering reliability of a finally obtained photovoltaic module.

In an embodiment, orthographic projections of all the first intermediate connection structures on the solar cell body are arranged in a staggered manner with orthographic projections of the second intermediate connection structures, corresponding to the first intermediate connection structures, on the solar cell body.

In an embodiment, a distance difference between a perpendicular midline of a connection line between the first edge connection structure and the second edge connection structure and a perpendicular midline of a connection line between the third edge connection structure and the fourth edge connection structure is less than 0.5 mm. Alternatively, the perpendicular midline of the connection line between the first edge connection structure and the second edge connection structure passes through one of the first intermediate connection structures. Alternatively, the perpendicular midline of the connection line between the third edge connection structure and the fourth edge connection structure passes through one of the second intermediate connection structures.

When the foregoing technical solution is adopted, a probability of bending or even hidden cracking of the solar cell body can be reduced while maintaining proper positions of the first intermediate connection structures or the second intermediate connection structures, to ensure connection strength and a connection effect of the conductive connector.

According to a second aspect, the present application further provides a photovoltaic module. The photovoltaic module includes a solar cell string. The solar cell string includes a plurality of solar cells, each of the plurality of solar cells being the solar cell according to the foregoing technical solutions; and a plurality of conductive connectors, configured to connect the plurality of solar cells in series.

Compared with the related art, beneficial effects of the photovoltaic module provided in the present application are the same as the beneficial effects of the solar cell in the foregoing technical solutions, and details are not described herein again.

In an embodiment, the plurality of solar cells arranged at intervals include a first solar cell and a second solar cell that are adjacent to each other. A respective conductive connector of the plurality of conductive connectors includes a first connection section located on a first surface of the first solar cell, a second connection section located on a second surface of the second solar cell, and a third connection section. The first connection section includes a first end section and a second end section. The first end section is soldered to a first edge connection structure of the first solar cell. The second end section is soldered to a second edge connection structure of the first solar cell. The second connection section includes a third end section and a fourth end section. The third end section is soldered to a third edge connection structure of the second solar cell. The fourth end section is soldered to a fourth edge connection structure of the second solar cell. The second end section and the third end section are connected by the third connection section.

It can be known with reference to the foregoing descriptions that a distance between the first edge connection structure and the first edge is less than a distance between the third edge connection structure and the first edge, and a distance between the second edge connection structure and the second edge is less than a distance between the fourth edge connection structure and the second edge. In view of the above, after actual soldering, the first surface of the solar cell body, the first edge connection structure, and the second edge connection structure are all subjected to a pulling force (which is referred to as a first pulling force for short for convenience of subsequent description) in a direction toward an interior of the solar cell body. The second surface of the solar cell body, the third edge connection structure, and the fourth edge connection structure are all subjected to a pulling force (which is referred to as a second pulling force for short for convenience of subsequent description) in a direction toward the interior of the solar cell body. When the foregoing solution is adopted, it can be ensured that a perpendicular midline of a connection line between the first edge connection structure and the second edge connection structure and a perpendicular midline of a connection line between the third edge connection structure and the fourth edge connection structure are close, and are located in a middle region of the solar cell. In this case, the first pulling force and the second pulling force can basically offset each other or offset each other, to basically balance or balance impact of pulling forces of an interconnector on the first surface and the second surface, so that impact of shrinking of the interconnector on the first surface of the solar cell body and impact of shrinking of the interconnector on the second surface of the solar cell body are balanced as much as possible, thereby reducing or eliminating a probability of bending or even hidden cracking of the solar cell body, to ensure quality of a finally obtained photovoltaic module.

### BRIEF DESCRIPTION OF THE DRAWINGS

The accompanying drawings described herein are used to provide a further understanding of the present application, and form a part of the present application. Exemplary embodiments of the present application and description thereof are used to explain the present application, and do not constitute any inappropriate limitation to the present application. In the accompanying drawings:
FIG. 1 is a schematic structural diagram of a first surface of a solar cell according to an embodiment of the present application;
FIG. 2 is a schematic structural diagram of a second surface of a solar cell according to an embodiment of the present application;
FIG. 3 is a schematic structural diagram of a photovoltaic module according to an embodiment of the present application; and
FIG. 4 is a schematic enlarged view of a partial structure of FIG. 3 according to an embodiment of the present application.

Reference signs:
1-solar cell body, 10-first surface, 11-second surface, 12-first edge, 13-second edge; 2-first electrode structure, 20-first connection structure, 21-first edge connection structure, 22-second edge connection structure, 23-first intermediate connection structure; 3-second electrode structure, 30-second connection structure, 31-third edge connection structure, 32-fourth edge connection structure, and 33-second intermediate connection structure; 4-conductive connector, 40-first connection section, 41-second connection section, 42-third connection section, 43-first end section, 44-second end section, 45-third end section, 46-fourth end section; 5-first solar cell, and 6-second solar cell.

### DETAILED DESCRIPTION

To make the technical problems to be resolved by, the technical solutions, and the beneficial effects of the present application clearer and more comprehensible, the following further describes the present application in detail with reference to the accompanying drawings and embodiments. It should be understood that, the specific embodiments described herein are merely used for describing the present application and are not intended to limit the present application.

It should be noted that when an element is described as being "fixed on" or "arranged on" another element, the element may be directly located on another element or indirectly located on another element. When an element is described as being "connected to" another element, the element may be directly connected to another element or indirectly connected to another element.

In addition, the terms "first" and "second" are used for descriptive purposes only and are not to be construed as indicating or implying relative importance or implicitly indicating the number of technical features indicated. Therefore, a feature defined by "first" or "second" may explicitly indicate or implicitly include one or more features. In the description of the present application, "a plurality of" means two or more, unless otherwise definitely and specifically limited. "Several" means one or more, unless otherwise definitely and specifically limited.

In the description of the present application, it should be understood that orientation or position relationships indicated by the terms such as "on", "below", "front", "rear", "left", "right", and the like are based on orientation or position relationships shown in the accompanying drawings, and are used only for ease and brevity of illustration of the present application and description, rather than indicating or implying that the mentioned device or element needs to have a particular orientation or needs to be constructed and operated in a particular orientation. Therefore, such terms should not be construed as a limitation to the present application.

In the description of the present application, it should be noted that, unless otherwise explicitly specified or defined, the terms such as "install", "connect", and "connection" should be understood in a broad sense. For example, the connection may be a fixed connection, a detachable connection, or an integral connection; or may be a mechanical connection or an electrical connection; or may be a direct connection, an indirect connection through an intermediate, or internal communication between two elements or an interaction relationship between two elements. A person of ordinary skill in the art can understand specific meanings of the terms in the present application based on specific situations.

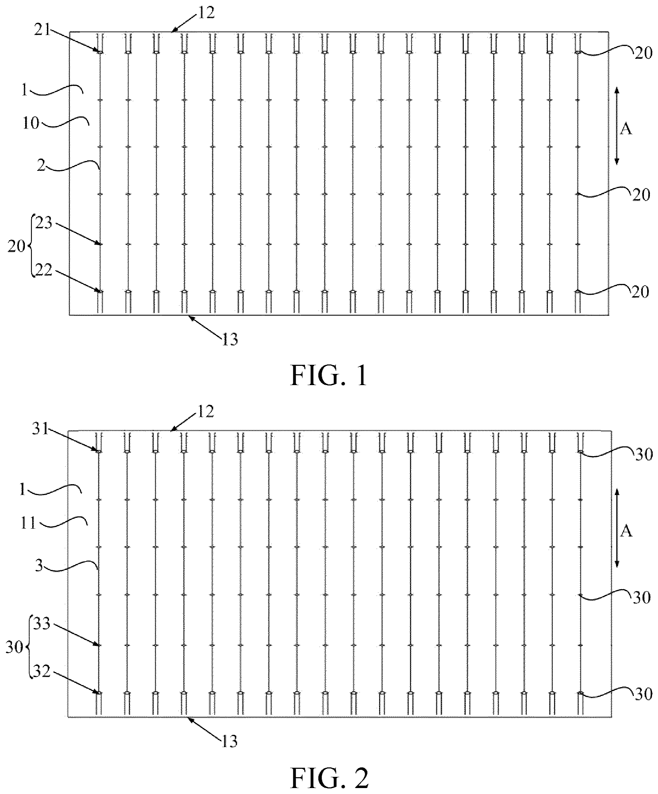

To resolve the foregoing technical problems, according to a first aspect, an embodiment of the present application provides a solar cell. Referring to FIG. 1 and FIG. 2, the solar cell includes a solar cell body 1. The solar cell body 1 includes a first surface 10 and a second surface 11 that are opposite, and a first electrode structure 2 and a second electrode structure 3 respectively formed on the first surface 10 and the second surface 11. Along a first direction A, the solar cell body 1 includes a first edge 12 and a second edge 13 that are opposite. A structure, a specification, and the like of the solar cell body can be set based on an actual situation, and are not specifically limited herein. The first direction is parallel to the surfaces of the solar cell body.

Referring to FIG. 1 and FIG. 2, the first electrode structure 2 includes at least two first connection structures 20 distributed at intervals along the first direction A. The second electrode structure 3 includes at least two second connection structures 30 distributed at intervals along the first direction.

Referring to FIG. 1, in some embodiments, the at least two first connection structures 20 include a first edge connection structure 21 close to the first edge 12 and a second edge connection structure 22 close to the second edge 13.

In an embodiment, the first electrode structure includes a busbar extending along the first direction, and at least two first connection structures distributed at intervals along the first direction and arranged on the busbar. The first electrode structure can include a plurality of busbars and a plurality of first connection structures arranged on the plurality of busbars. Therefore, the foregoing "at least two first connection structures distributed at intervals along the first direction" can be understood as first connection structures on a same busbar. Further, for convenience of subsequent description, the at least two first connection structures include a first edge connection structure close to the first edge and a second edge connection structure close to the second edge.

Referring to FIG. 2, in some embodiments, the at least two second connection structures 30 include a third edge connection structure 31 close to the first edge 12 and a fourth edge connection structure 32 close to the second edge 13.

In an embodiment, the second electrode structure includes a busbar extending along the first direction, and at least two second connection structures distributed at intervals along the first direction and arranged on the busbar. The second electrode structure can include a plurality of bus bars and a plurality of second connection structures arranged on the plurality of busbars. Therefore, the foregoing "at least two second connection structures distributed at intervals along the first direction" can be understood as second connection structures on a same busbar. Further, for convenience of subsequent description, the at least two second connection structures include a third edge connection structure close to the first edge and a fourth edge connection structure close to the second edge.

Referring to FIG. 1 to FIG. 4, a distance L1 between the first edge connection structure 21 and the first edge 12 is less than a distance L2 between the third edge connection structure 31 and the first edge 12. A distance L3 between the second edge connection structure 22 and the second edge 13 is less than a distance L4 between the third edge connection structure 31 and the second edge 13. In view of the above, an orthographic projection of the first edge connection structure 21 on the solar cell body 1 does not completely coincide with an orthographic projection of the third edge connection structure 31, corresponding to the first edge connection structure 21, on the solar cell body 1. An orthographic projection of the second edge connection structure 22 on the solar cell body 1 does not completely coincide with an orthographic projection of the fourth edge connection structure 32, corresponding to the second edge connection structure 22, on the solar cell body 1. In other words, the first edge connection structure 21 and the third edge connection structure 31 are arranged in a partially staggered manner, and the second edge connection structure 22 and the third edge connection structure 31 are arranged in a partially staggered manner. In this case, during actual soldering, a probability that soldering stress concentration occurs at the first connection structures 20 and the second connection structures 30 on the first surface 10 and the second surface 11 of the solar cell can be reduced, to ensure soldering reliability of a finally obtained photovoltaic module.

Further, a distance between the first edge connection structure and the first edge is less than a distance between the third edge connection structure and the first edge. A distance between the second edge connection structure and the second edge is less than a distance between the fourth edge connection structure and the second edge. In view of the above, after actual soldering, the first surface of the solar cell body, the first edge connection structure, and the second edge connection structure are all subjected to a pulling force (which is referred to as a first pulling force for short for convenience of subsequent description) in a direction toward an interior of the solar cell body. The second surface of the solar cell body, the third edge connection structure, and the fourth edge connection structure are all subjected to a pulling force (which is referred to as a second pulling force for short for convenience of subsequent description) in a direction toward the interior of the solar cell body. When the foregoing solution is adopted, it can be ensured that a perpendicular midline of a connection line between the first edge connection structure and the second edge connection structure and a perpendicular midline of a connection line between the third edge connection structure and the fourth edge connection structure are close, and are located in a middle region of the solar cell. In this case, the first pulling force and the second pulling force can basically offset each other or offset each other, to basically balance or balance impact of pulling forces of an interconnector on the first surface and the second surface, so that impact of shrinking of the interconnector on the first surface of the solar cell body and impact of shrinking of the interconnector on the second surface of the solar cell body are balanced as much as possible, thereby reducing or eliminating a probability of bending or even hidden cracking of the solar cell body, to ensure quality of a finally obtained photovoltaic module.

In an embodiment, referring to FIG. 1 to FIG. 4, a difference between the distance L1 between the first edge connection structure 21 and the first edge 12 and the distance L2 between the third edge connection structure 31 and the first edge 12 is equal to a difference between the distance L3 between the second edge connection structure 22 and the second edge 13 and the distance L4 between the third edge connection structure 31 and the second edge 13.

Referring to FIG. 1 to FIG. 4, when the foregoing solution is adopted, a perpendicular midline of a connection line M between the first edge connection structure 21 and the second edge connection structure 22 and a perpendicular midline N of a connection line between the third edge connection structure 31 and the fourth edge connection structure 32 are infinitely close to or coincide with each other. In this case, the first pulling force and the second pulling force can almost completely offset each other, which can better prevent the solar cell body from bending or even hidden cracking.

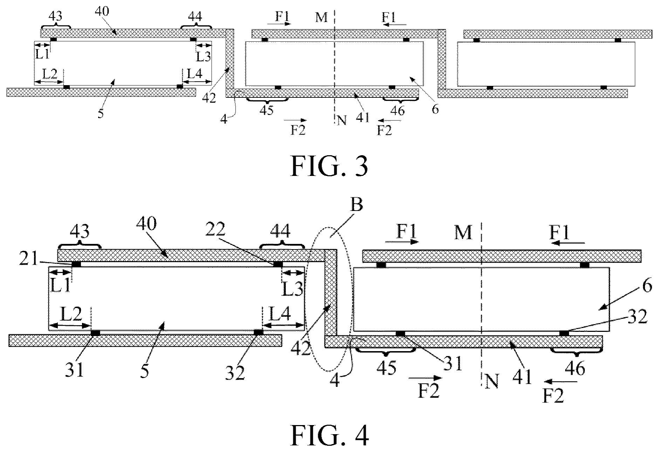

In an embodiment, referring to FIG. 4, the distance L1 between the first edge connection structure 21 and the first edge 12 is greater than or equal to 4.5 mm and less than or equal to 8.5 mm. For example, the distance between the first edge connection structure 21 and the first edge 12 is 4.5 mm, 5 mm, 5.5 mm, 6 mm, 6.5 mm, 7 mm, 7.5 mm, 8 mm, 8.5 mm, or the like.

The distance L3 between the second edge connection structure 22 and the second edge 13 is greater than or equal to 5.5 mm and less than or equal to 9.5 mm. For example, the distance between the second edge connection structure 22 and the second edge 13 is 5.5 mm, 6 mm, 6.5 mm, 7 mm, 7.5 mm, 8 mm, 8.5 mm, 9 mm, 9.5 mm, or the like.

The distance L2 between the third edge connection structure 31 and the first edge 12 is greater than or equal to 5 mm and less than or equal to 9 mm. For example, the distance between the third edge connection structure 31 and the first edge 12 is 5 mm, 5.5 mm, 6 mm, 6.5 mm, 7 mm, 7.5 mm, 8 mm, 8.5 mm, 9 mm, or the like.

The distance L4 between the third edge connection structure 31 and the second edge 13 is greater than or equal to 6.5 mm and less than or equal to 10.5 mm. For example, the distance between the third edge connection structure 31 and the second edge 13 is 6.5 mm, 7 mm, 7.5 mm, 8 mm, 8.5 mm, 9 mm, 9.5 mm, 10 mm, 10.5 mm, or the like.

When the foregoing technical solution is adopted, stress concentration is reduced in response to ensuring a conductive connector 4 (for example, an interconnector) is stably soldered to the first edge connection structure 21, the second edge connection structure 22, the third edge connection structure 31, and the third edge connection structure 31 after actual soldering.

In an embodiment, along the first direction, an overlap rate of an orthographic projection of the first edge connection structure on the solar cell body and an orthographic projection of the third edge connection structure, corresponding to the first edge connection structure, on the solar cell body is greater than or equal to 0 and less than 70%. For example, the overlap rate is 0, 1%, 5%, 13%, 20%, 50%, 60%, 69%, or the like. The overlap rate refers to a ratio of a length of an overlapping portion between the orthographic projection of the first edge connection structure and the orthographic projection of the third edge connection structure in the first direction to a length of the orthographic projection of the first edge connection structure in the first direction, or a ratio of a length of an overlapping portion between the orthographic projection of the first edge connection structure and the orthographic projection of the third edge connection structure in the first direction to a length of the orthographic projection of the third edge connection structure in the first direction, or a ratio of an area of an overlapping portion between the orthographic projection of the first edge connection structure and the orthographic projection of the third edge connection structure to an area of the orthographic projection of the first edge connection structure, or a ratio of an area of an overlapping portion between the orthographic projection of the first edge connection structure and the orthographic projection of the third edge connection structure to an area of the orthographic projection of the third edge connection structure.

Along the first direction, an overlap rate of an orthographic projection of the second edge connection structure on the solar cell body and an orthographic projection of the fourth edge connection structure, corresponding to the second edge connection structure, on the solar cell body is greater than or equal to 0 and less than 70%. For example, the overlap rate is 0, 1%, 5%, 13%, 20%, 35%, 50%, 60%, 69%, or the like. The overlap rate refers to a ratio of a length of an overlapping portion between the orthographic projection of the second edge connection structure and the orthographic projection of the fourth edge connection structure in the first direction to a length of the orthographic projection of the second edge connection structure in the first direction, or a ratio of a length of an overlapping portion between the orthographic projection of the second edge connection structure and the orthographic projection of the fourth edge connection structure in the first direction to a length of the orthographic projection of the fourth edge connection structure in the first direction, or a ratio of an area of an overlapping portion between the orthographic projection of the second edge connection structure and the orthographic projection of the fourth edge connection structure to an area of the orthographic projection of the second edge connection structure, or a ratio of an area of an overlapping portion between the orthographic projection of the second edge connection structure and the orthographic projection of the fourth edge connection structure to an area of the orthographic projection of the fourth edge connection structure.

When the foregoing technical solution is adopted, when the two overlap rates are both equal to 0, the first edge connection structure and the third edge connection structure are completely staggered, and the second edge connection structure and the fourth edge connection structure are completely staggered. In this case, during actual soldering, a probability that soldering stress concentration occurs at the first connection structures and the second connection structures on the first surface and the second surface of the solar cell can be further reduced, to ensure soldering reliability of a finally obtained photovoltaic module. Further, the overlap rate is less than 70%, which not only avoids stress concentration caused by an excessively large overlap rate, but also provides high flexibility for design of the pads.

In an embodiment, along the first direction, an overlap rate of an orthographic projection of the first edge connection structure on the solar cell body and an orthographic projection of the third edge connection structure, corresponding to the first edge connection structure, on the solar cell body is equal or not equal to an overlap rate of an orthographic projection of the second edge connection structure on the solar cell body and an orthographic projection of the fourth edge connection structure, corresponding to the second edge connection structure, on the solar cell body.

In an embodiment, along the first direction, when an overlap rate of an orthographic projection of the first edge connection structure on the solar cell body and an orthographic projection of the third edge connection structure, corresponding to the first edge connection structure, on the solar cell body is equal to 0, an overlap rate of an orthographic projection of the second edge connection structure on the solar cell body and an orthographic projection of the fourth edge connection structure, corresponding to the second edge connection structure, on the solar cell body is greater than 50% and less than 100%. For example, the overlap rate is 51%, 55%, 60%, 65%, 70%, 75%, 80%, 85%, 90%, 99%, or the like. Alternatively, along the first direction, when the overlap rate of the orthographic projection of the second edge connection structure on the solar cell body and the orthographic projection of the fourth edge connection structure, corresponding to the second edge connection structure, on the solar cell body is equal to 0, the overlap rate of the orthographic projection of the first edge connection structure on the solar cell body and the orthographic projection of the third edge connection structure, corresponding to the first edge connection structure, on the solar cell body is greater than 50% and equal to 100%. For example, the overlap rate is 51%, 55%, 60%, 65%, 70%, 75%, 80%, 85%, 90%, 99%, or the like.

In this case, in response to reducing a probability that soldering stress concentration occurs at the first connection structures and the second connection structures on the first surface and the second surface of the solar cell, concentrated distribution of the first edge connection structure and the second edge connection structure can be avoided or concentrated distribution of the third edge connection structure and the fourth edge connection structure can be avoided, to ensure uniform current collection.

In an embodiment, referring to FIG. 1, the first connection structures 20 further include first intermediate connection structures 23 located between the first edge connection structure 21 and the second edge connection structure 22. For example, a quantity of the first intermediate connection structures 23 is greater than or equal to 5 and less than or equal to 9, and for example, is 5, 6, 7, 8, or 9. Further, when the first connection structures 20 include a plurality of first intermediate connection structures 23. The plurality of first intermediate connection structures 23 are arranged at equal intervals or at different intervals.

Heights of the first intermediate connection structures are equal to a height of the first edge connection structure. The height of the first edge connection structure is equal to a height of the second edge connection structure.

In this case, it can be ensured that the conductive connector is firmly connected to the first edge connection structure, the second edge connection structure, and the first intermediate connection structures, to ensure quality of the solar cell. Further, heights of the first intermediate connection structures being greater than a height of the first edge connection structure and a height of the second edge connection structure can also be avoided from causing the conductive connector to be raised, thereby avoiding hidden cracking or fragmentation of the solar cell.

Further, Cross-sectional areas of the first intermediate connection structures are smaller than a cross-sectional area of the first edge connection structure. The cross-sectional area of the first edge connection structure is equal to a cross-sectional area of the second edge connection structure. Cross sections of the first intermediate connection structures, a cross section of the first edge connection structure, and a cross section of the first edge connection structure are all parallel to the solar cell body.

In this case, an area by which the first intermediate connection structures shield the solar cell body can be reduced, to improve utilization of light by the solar cell, thereby improving efficiency of the solar cell.

In an embodiment, referring to FIG. 2, the second connection structures 30 further include second intermediate connection structures 33 located between the third edge connection structure 31 and the fourth edge connection structure 32. For example, a quantity of the second intermediate connection structures 33 is greater than or equal to 5 and less than or equal to 9, and for example, is 5, 6, 7, 8, or 9. A quantity of the first intermediate connection structures 23 and a quantity of the second intermediate connection structures 33 are equal or not equal. Further, when the second connection structures 30 include a plurality of second intermediate connection structures 33. The plurality of second intermediate connection structures 33 are arranged at equal intervals or at different intervals.

Heights of the second intermediate connection structures are equal to a height of the third edge connection structure. The height of the third edge connection structure is equal to a height of the fourth edge connection structure.

In this case, it can be ensured that the conductive connector is firmly connected to the third edge connection structure, the fourth edge connection structure, and the second intermediate connection structures, to ensure quality of the solar cell. Further, heights of the second intermediate connection structures being greater than a height of the third edge connection structure and a height of the fourth edge connection structure can also be avoided from causing the conductive connector to be raised, thereby avoiding hidden cracking or fragmentation of the solar cell.

Further, cross-sectional areas of the second intermediate connection structures are smaller than a cross-sectional area of the third edge connection structure. The cross-sectional area of the third edge connection structure is equal to a cross-sectional area of the fourth edge connection structure. Cross sections of the second intermediate connection structures, a cross section of the third edge connection structure, and a cross section of the fourth edge connection structure are all parallel to the solar cell body.

In this case, an area by which the second intermediate connection structures shield the solar cell body can be reduced, to improve utilization of light by the solar cell, thereby improving efficiency of the solar cell.

An overlapping relationship between the orthographic projections of the first intermediate connection structures on the solar cell body and the orthographic projections of the second intermediate connection structures on the solar cell body is described below by using two possible cases as examples.

Example 1: The at least two first connection structures include at least two first intermediate connection structures. Orthographic projections of half of the first intermediate connection structures on the solar cell body do not overlap with orthographic projections of the second intermediate connection structures on the solar cell body.

In this case, during actual soldering, a probability that soldering stress concentration occurs at the first connection structures and the second connection structures on the first surface and the second surface of the solar cell can be further reduced, to ensure soldering reliability of a finally obtained photovoltaic module.

Example 2: Orthographic projections of all the first intermediate connection structures on the solar cell body are arranged in a staggered manner with orthographic projections of the second intermediate connection structures, corresponding to the first intermediate connection structures, on the solar cell body.

In an embodiment, a distance difference between a perpendicular midline of a connection line between the first edge connection structure and the second edge connection structure and a perpendicular midline of a connection line between the third edge connection structure and the fourth edge connection structure is less than 0.5 mm. For example, the distance difference is 0.49 mm, 0.45 mm, 0.43 mm, 0.38 mm, 0.35 mm, 0.2 mm, 0.1 mm, or the like. Alternatively, the perpendicular midline of the connection line between the first edge connection structure and the second edge connection structure passes through one of the first intermediate connection structures. Alternatively, the perpendicular midline of the connection line between the third edge connection structure and the fourth edge connection structure passes through one of the second intermediate connection structures.

When the foregoing technical solution is adopted, a probability of bending or even hidden cracking of the solar cell body can be reduced while maintaining proper positions of the first intermediate connection structures or the second intermediate connection structures, to ensure connection strength and a connection effect of the conductive connector.

According to a second aspect, an embodiment of the present application further provides a photovoltaic module. The photovoltaic module includes a solar cell string. The solar cell string includes a plurality of solar cells arranged at intervals, each of the plurality of solar cells being the solar cell according to the foregoing technical solutions; and a plurality of conductive connectors, configured to connect the plurality of solar cells in series.

Beneficial effects of the photovoltaic module provided in an embodiment of the present application are the same as the beneficial effects of the solar cell in the foregoing technical solutions, and details are not described herein again.

The foregoing conductive connectors are interconnectors or other connectors configured to connect solar cells. When the conductive connectors are interconnectors, the foregoing interconnectors are interconnectors whose cross sections are circular, triangular, or rectangular. Preferably, interconnectors whose cross sections are circular are used. In this case, mechanical stress at a connection between solar cells can be dealt with, a hidden cracking problem of a high-density photovoltaic module can be eliminated, and reliability of the photovoltaic module can be improved.

In an embodiment, referring to FIG. 1 to FIG. 4, the plurality of solar cells arranged at intervals include a first solar cell 5 and a second solar cell 6 that are adjacent to each other. A respective conductive connector of the plurality of conductive connectors 4 includes a first connection section 40 located on a first surface 10 of the first solar cell 5, a second connection section 41 located on a second surface 11 of the second solar cell 6, and a third connection section 42. The first connection section 40 includes a first end section 43 and a second end section 44. The first end section 43 is soldered to a first edge connection structure 21 of the first solar cell 5. The second end section 44 is soldered to a second edge connection structure 22 of the first solar cell 5. The second connection section 41 includes a third end section 45 and a fourth end section 46. The third end section 45 is soldered to a third edge connection structure 31 of the second solar cell 6. The fourth end section 46 is soldered to a fourth edge connection structure 32 of the second solar cell 6. The second end section 44 and the third end section 45 are connected by the third connection section 42.

When the solar cells are soldered in series, shrinkage stress occurs when the interconnectors are subsequently cooled. Because the interconnectors are soldered to the first connection structures 20 and the second connection structures 30 of the solar cells, the shrinkage stress causes undesirable pulling forces to the first connection structures 20 and the second connection structures 30 of the solar cells, especially for a double-sided solar cell. Because two opposite surfaces of a double-sided solar cell both have electrode structures, and are soldered to interconnectors, it is more prone to bending of the solar cell body 1, or it is more prone to severe damage to the first connection structures 20 and the second connection structures 30 due to uneven distribution of pulling forces on the solar cell body 1.

For example, after actual soldering, because an interconnector has a large movable space (for example, a region B in FIG. 4) at a position between two adjacent solar cells, shrinkage stress can be well released when the interconnector is cooled. However, on the first surface 10 of the solar cell body 1, a part of an interconnector located between the first edge connection structure 21 and the second edge connection structure 22 does not have enough space for releasing shrinkage stress, and the interconnector is fixedly soldered to the first edge connection structure 21 and the second edge connection structure 22 and is immovable. The first edge connection structure 21 and the second edge connection structure 22 are all subjected to a pulling force (which is referred to as a first pulling force F1 for short for convenience of subsequent description) in a direction toward an interior of the solar cell body. The first pulling force is large, and there is no pulling force in an opposite direction for balance. A pulling force center of the first pulling force can be simply understood as a center position of the first edge connection structure 21 and the second edge connection structure 22.

Similarly, on the second surface 11 of the solar cell body 1, a part of an interconnector located between the third edge connection structure 31 and the fourth edge connection structure 32 does not have enough space for releasing shrinkage stress, and the interconnector is fixedly soldered to the third edge connection structure 31 and the fourth edge connection structure 32 and is immovable. The third edge connection structure 31 and the fourth edge connection structure 32 are all subjected to a pulling force (which is referred to as a second pulling force F2 for short for convenience of subsequent description) in a direction toward an interior of the solar cell body. The second pulling force is large, and there is no pulling force in an opposite direction for balance. A pulling force center of the second pulling force can be simply understood as a center position of the third edge connection structure 31 and the fourth edge connection structure 32.

In the related art, arrangement positions of four edge connection structures cannot enable the second pulling force to balance impact of the first pulling force on the first surface. In this case, the solar cell body is caused to warp.

It can be known with reference to the foregoing descriptions that a distance between the first edge connection structure and the first edge is less than a distance between the third edge connection structure and the first edge, and a distance between the second edge connection structure and the second edge is less than a distance between the fourth edge connection structure and the second edge. In view of the above, after actual soldering, the first surface of the solar cell body, the first edge connection structure, and the second edge connection structure are all subjected to a pulling force (which is referred to as a first pulling force for short for convenience of subsequent description) in a direction toward an interior of the solar cell body. The second surface of the solar cell body, the third edge connection structure, and the fourth edge connection structure are all subjected to a pulling force (which is referred to as a second pulling force for short for convenience of subsequent description) in a direction toward the interior of the solar cell body. When the foregoing solution is adopted, it can be ensured that a perpendicular midline of a connection line between the first edge connection structure 21 and the second edge connection structure 22 and a perpendicular midline of a connection line between the third edge connection structure 31 and the fourth edge connection structure 32 are close, and are located in a middle region of the solar cell. In this case, the first pulling force F1 and the second pulling force F2 can basically offset each other or offset each other, to basically balance or balance impact of pulling forces of an interconnector on the first surface and the second surface, so that impact of shrinking of the interconnector (that is, the conductive connector) on the first surface of the solar cell body and impact of shrinking of the interconnector on the second surface of the solar cell body are balanced as much as possible, thereby reducing or eliminating a probability of bending or even hidden cracking of the solar cell body, to ensure quality of a finally obtained photovoltaic module.

In an embodiment, when a perpendicular midline of a connection line between the first edge connection structure 21 and the second edge connection structure 22 and a perpendicular midline of a connection line between the third edge connection structure 31 and the fourth edge connection structure 32 are infinitely close to or coincide with each other. The first pulling force F1 and the second pulling force F2 can almost completely offset each other, which can better prevent the solar cell body from bending or even hidden cracking.

In the descriptions of the foregoing embodiments, the described specific features, structures, materials, or characteristics may be combined in a proper manner in any one or more of the embodiments or examples.

The foregoing descriptions are merely specific embodiments of the present application, but are not intended to limit the protection scope of the present application. Any variation or replacement readily figured out by a person skilled in the art within the technical scope disclosed in the present application shall fall within the protection scope of the present application. Therefore, the protection scope of the present application shall be subject to the protection scope of the claims.

## Claims

1. A solar cell, comprising a solar cell body having a first surface and a second surface opposite to the first surface, wherein the solar cell body has a first edge and a second edge opposite to the first edge along a first direction; and
a first electrode structure and a second electrode structure formed on the first surface and the second surface, respectively, wherein:
the first electrode structure comprises at least two first connection structures distributed at intervals along the first direction;
the second electrode structure comprises at least two second connection structures distributed at intervals along the first direction;
the at least two first connection structures comprise a first edge connection structure close to the first edge and a second edge connection structure close to the second edge;
the at least two second connection structures comprise a third edge connection structure close to the first edge and a fourth edge connection structure close to the second edge;
a distance between the first edge connection structure and the first edge is less than a distance between the third edge connection structure and the first edge; and
a distance between the second edge connection structure and the second edge is less than a distance between the fourth edge connection structure and the second edge.

2. The solar cell according to claim 1, wherein a difference between the distance between the first edge connection structure and the first edge and the distance between the third edge connection structure and the first edge is equal to a difference between the distance between the second edge connection structure and the second edge and the distance between the fourth edge connection structure and the second edge.

3. The solar cell according to claim 1, wherein:
the distance between the first edge connection structure and the first edge is greater than or equal to 4.5 mm and less than or equal to 8.5 mm;
the distance between the second edge connection structure and the second edge is greater than or equal to 5.5 mm and less than or equal to 9.5 mm;
the distance between the third edge connection structure and the first edge is greater than or equal to 5 mm and less than or equal to 9 mm; and
the distance between the fourth edge connection structure and the second edge is greater than or equal to 6.5 mm and less than or equal to 10.5 mm.

4. The solar cell according to claim 1, wherein along the first direction, an overlap rate of an orthographic projection of the first edge connection structure on the solar cell body and an orthographic projection of the third edge connection structure, corresponding to the first edge connection structure, on the solar cell body is greater than or equal to 0 and less than 70%; and
along the first direction, an overlap rate of an orthographic projection of the second edge connection structure on the solar cell body and an orthographic projection of the fourth edge connection structure, corresponding to the second edge connection structure, on the solar cell body is greater than or equal to 0 and less than 70%.

5. The solar cell according to claim 1, wherein along the first direction, an overlap rate of an orthographic projection of the first edge connection structure on the solar cell body and an orthographic projection of the third edge connection structure, corresponding to the first edge connection structure, on the solar cell body is equal or not equal to an overlap rate of an orthographic projection of the second edge connection structure on the solar cell body and an orthographic projection of the fourth edge connection structure, corresponding to the second edge connection structure, on the solar cell body.

6. The solar cell according to claim 1, wherein along the first direction, when an overlap rate of an orthographic projection of the first edge connection structure on the solar cell body and an orthographic projection of the third edge connection structure, corresponding to the first edge connection structure, on the solar cell body is equal to 0, an overlap rate of an orthographic projection of the second edge connection structure on the solar cell body and an orthographic projection of the fourth edge connection structure, corresponding to the second edge connection structure, on the solar cell body is greater than 50% and less than 100%; or
along the first direction, when the overlap rate of the orthographic projection of the second edge connection structure on the solar cell body and the orthographic projection of the fourth edge connection structure, corresponding to the second edge connection structure, on the solar cell body is equal to 0, the overlap rate of orthographic projection of the first edge connection structure on the solar cell body and the orthographic projection of the third edge connection structure, corresponding to the first edge connection structure, on the solar cell body is greater than 50% and equal to 100%.

7. The solar cell according to claim 1, wherein the at least two first connection structures further comprise first intermediate connection structures located between the first edge connection structure and the second edge connection structure.

8. The solar cell according to claim 7, wherein heights of the first intermediate connection structures are equal to a height of the first edge connection structure;
the height of the first edge connection structure is equal to a height of the second edge connection structure;
cross-sectional areas of the first intermediate connection structures are smaller than a cross-sectional area of the first edge connection structure;
the cross-sectional area of the first edge connection structure is equal to a cross-sectional area of the second edge connection structure; and
cross sections of the first intermediate connection structures, a cross section of the first edge connection structure, and a cross section of the second edge connection structure are all parallel to the solar cell body.

9. The solar cell according to claim 7, wherein the at least two second connection structures further comprise second intermediate connection structures located between the third edge connection structure and the fourth edge connection structure.

10. The solar cell according to claim 9, wherein heights of the second intermediate connection structures are equal to a height of the third edge connection structure;
the height of the third edge connection structure is equal to a height of the fourth edge connection structure;
cross-sectional areas of the second intermediate connection structures are smaller than a cross-sectional area of the third edge connection structure;
the cross-sectional area of the third edge connection structure is equal to a cross-sectional area of the fourth edge connection structure; and
cross sections of the second intermediate connection structures, a cross section of the third edge connection structure, and a cross section of the fourth edge connection structure are all parallel to the solar cell body.

11. The solar cell according to claim 9, wherein the at least two first connection structures comprise at least two first intermediate connection structures; and
orthographic projections of half of the first intermediate connection structures on the solar cell body do not overlap with orthographic projections of the second intermediate connection structures on the solar cell body.

12. The solar cell according to claim 9, wherein orthographic projections of all the first intermediate connection structures on the solar cell body are arranged in a staggered manner with orthographic projections of the second intermediate connection structures, corresponding to the first intermediate connection structure, on the solar cell body.

13. The solar cell according to claim 9, wherein a distance difference between a perpendicular midline of a connection line between the first edge connection structure and the second edge connection structure and a perpendicular midline of a connection line between the third edge connection structure and the fourth edge connection structure is less than 0.5 mm; or
the perpendicular midline of the connection line between the first edge connection structure and the second edge connection structure passes through one of the first intermediate connection structures; or
the perpendicular midline of the connection line between the third edge connection structure and the fourth edge connection structure passes through one of the second intermediate connection structures.

14. A photovoltaic module, comprising a solar cell string, wherein the solar cell string comprises:
a plurality of solar cells arranged at intervals, each of the plurality of solar cells being the solar cell according to any one of claims 1 to 13; and
a plurality of conductive connectors, configured to connect the plurality of solar cells in series.

15. The photovoltaic module according to claim 14, wherein the plurality of solar cells arranged at intervals comprise a first solar cell and a second solar cell adjacent to the first solar cell, and a respective conductive connector of the plurality of conductive connectors comprises a first connection section located on a first surface of the first solar cell, a second connection section located on a second surface of the second solar cell, and a third connection section; and
the first connection section comprises a first end section and a second end section, the first end section being soldered to a first edge connection structure of the first solar cell, and the second end section being soldered to a second edge connection structure of the first solar cell;
the second connection section comprises a third end section and a fourth end section, the third end section being soldered to a third edge connection structure of the second solar cell, and the fourth end section being soldered to a fourth edge connection structure of the second solar cell; and
the second end section and the third end section are connected by the third connection section.
